# EUROPÄISCHE PATENTSCHRIFT

(11) **EP 1 114 455 B1**
(45) Veröffentlichungstag und Bekanntmachung des Hinweises auf die Patenterteilung: **15.11.2006**
(21) Anmeldenummer: 99945918.3
(22) Anmeldetag: 05.07.1999
(51) Int. Cl.: H01L 21/8242, H01L 27/108

(54) **VERFAHREN ZUM HERSTELLEN EINER SPEICHERZELLE**
METHOD FOR PRODUCING A STORAGE CELL
PROCEDE DE PRODUCTION D'UNE CELLULE MEMOIRE

(30) Priorität: 31.07.1998 DE 19834649
(43) Veröffentlichungstag der Anmeldung: 11.07.2001
(73) Patentinhaber: Qimonda AG, 81739 München (DE)
(72) Erfinder: WILLER, Josef, D-85521 Riemerling (DE); HOFMANN, Franz, D-80995 München (DE); SCHLÖSSER, Till, D-81825 München (DE); KRAUTSCHNEIDER, Wolfgang, D-21149 Hamburg (DE)
(74) Vertreter: Kottmann, Heinz Dieter
(86) Internationale Anmeldenummer: PCT/DE1999/002080
(87) Internationale Veröffentlichungsnummer: WO 2000/008682

(56) Entgegenhaltungen:
- DE-C- 19 640 273
- US-A- 5 701 647
- US-A- 5 757 612
- US-A- 5 793 076

## Beschreibung

Die vorliegende Erfindung betrifft ein Verfahren zum Herstellen einer Speicherzelle aus wenigstens einem Auswahltransistor und einem Speicherkondensator mit einem Hochepsilon- oder ferroelektrischem Dielektrikum, bei dem der Auswahltransistor in einer ersten Ebene und der Speicherkondensator in einer zweiten Ebene in bzw. über einem Halbleiterkörper angeordnet werden, wobei die erste Ebene mit der zweiten Ebene elektrisch durch einen ersten Plug ("Stöpsel") aus Silizium verbunden ist, an den sich ein zweiter Plug aus Silizium anschließt, der mit einer Speicherknotenelektrode des Speicherkondensators elektrisch verbunden ist. Eine derartige Speicherzelle ist aus DE 195 40 213 A1 und aus DE-C-196 40 273 bekannt. Außerdem ist in DE 195 43 539 C1 ein Verfahren zum Herstellen einer Speicheranordnung beschrieben, bei dem in eine auf einem Halbleiterkörper vorgeschlagenen ersten Isolierschicht erste Plugs eingebracht werden. Sodann werden in einer auf dieser ersten Isolierschicht aufgetragenen zweiten Isolierschicht zweite Plugs über den ersten Plugs vorgesehen.

Bei der Herstellung von solchen Speicherzellen erfordert das Dielektrikum aus Hochepsilon- oder ferroelektrischem Material, wie beispielsweise Bariumstrontiumtitanat (BST) oder Wismutbariumtantalat (SBT) eine Temperung mit Sauerstoff. Bei einer solchen Temperung wird aber jede freiliegende Siliziumschicht aufoxidiert, so daß sie ihre elektrische Leitfähigkeit verliert. Bei Speicherzellen wird polykristallines Silizium in Plugs verwendet, um den Auswahltransistor mit einer Elektrode des darüber angeordneten Stapel-Speicherkondensators zu verbinden. Diese Plugs sind Anschlußschichten, die eine elektrische Verbindung zwischen dem Speicherkondensator und dem Auswahltransistor sicherstellen. Um nun bei der Temperung von BST oder SBT die Aufoxidation des polykristallinen Siliziums im Plug zwischen Auswahltransistor und Speicherkondensator zu verhindern, wird die Oberfläche des Plugs bisher gewöhnlich mit einer Barriereschicht überzogen, damit keine Sauerstoffdiffusion zum polykristallinen Silizium mehr stattfinden kann. Es ist jedoch schwierig und auch aufwendig, geeignete Materialien für solche Barriereschichten zu finden, da diese bei der Temperung von BST bzw. SBT hohe Temperaturen im Bereich von 700 und 800°C aushalten müssen.

Es ist daher Aufgabe der vorliegenden Erfindung, ein Verfahren zum Herstellen einer Speicherzelle zu schaffen, bei dem ohne Verwendung einer Barriereschicht der Auswahltransistor mit dem Speicherkondensator so elektrisch gut verbunden werden kann, daß eine Aufoxidation von Silizium nicht auftreten kann.

Diese Aufgabe wird bei einem Verfahren der eingangs genannten Art erfindungsgemäß durch die Merkmale des kennzeichnenden Teils des Anspruchs 1 gelöst.

Der erste Plug und der zweite Plug werden vorzugsweise aus polykristallinem Silizium gebildet. Alternativ können sie auch aus amorphem Silizium realisiert werden.

Die Isolierschicht wird vorzugsweise aus Siliziumnitrid gebildet.

Bei dem erfindungsgemäßen Verfahren wird also zuerst die Zellplattenelektrode der Speicherkondensatoren mittels einer Hilfsstruktur in der Gestalt eines netzförmigen Musters erzeugt. In diese Hilfsstruktur, die vorzugsweise aus polykristallinem Silizium gebildet wird, werden sodann Kontaktlöcher für den Zellknotenanschluß geätzt. Diese Kontaktlöcher werden anschließend mit einer Isolierschicht, beispielsweise aus Siliziumnitrid, als Platzhalter aufgefüllt. Es schließt sich sodann die Herstellung des Speicherkondensators an, bei dem ohne weiteres eine oxidierende Temperung von BST oder SBT bei hohen Temperaturen vorgenommen werden kann, da der vom Auswahltransistor wegführende Plug zu dieser Zeit noch mit der Isolierschicht abgedeckt ist, so daß eine Oxidation des Siliziums dieses Plugs zuverlässig vermieden wird. Erst nach dieser Temperung wird dann der "Platzhalter" aus der Isolierschicht durch Silizium ersetzt, das den zweiten Plug bildet.

Die Elektroden selbst können beispielsweise durch chemische Dampfabscheidung (CVD-Abscheidung) von Ruthenium (Ru) oder aber auch durch Sputtern von Platin (Pt) und Auffüllung der Lunker mit Wolfram gebildet werden. Anstelle von Ruthenium, Platin bzw. Wolfram können aber auch andere Materialien eingesetzt werden, die insbesondere in der US 5 554 866 angegeben sind.

Nachfolgend wird die Erfindung anhand der Zeichnungen näher erläutert. Es zeigen:
- Fig. 1 bis 7: Schnittbilder zur Erläuterung eines ersten Ausführungsbeispiels des erfindungsgemäßen Verfahrens zum Herstellen einer Speicherzelle,
- Fig. 8: eine Draufsicht auf die nach dem ersten Ausführungsbeispiel hergestellte Speicherzelle,
- Fig. 9 bis 14: Schnittbilder zur Erläuterung eines zweiten Ausführungsbeispiels des erfindungsgemäßen Verfahrens zum Herstellen einer Speicherzelle und
- Fig. 15: eine Draufsicht auf die nach dem zweiten Ausführungsbeispiel hergestellte Speicherzelle.

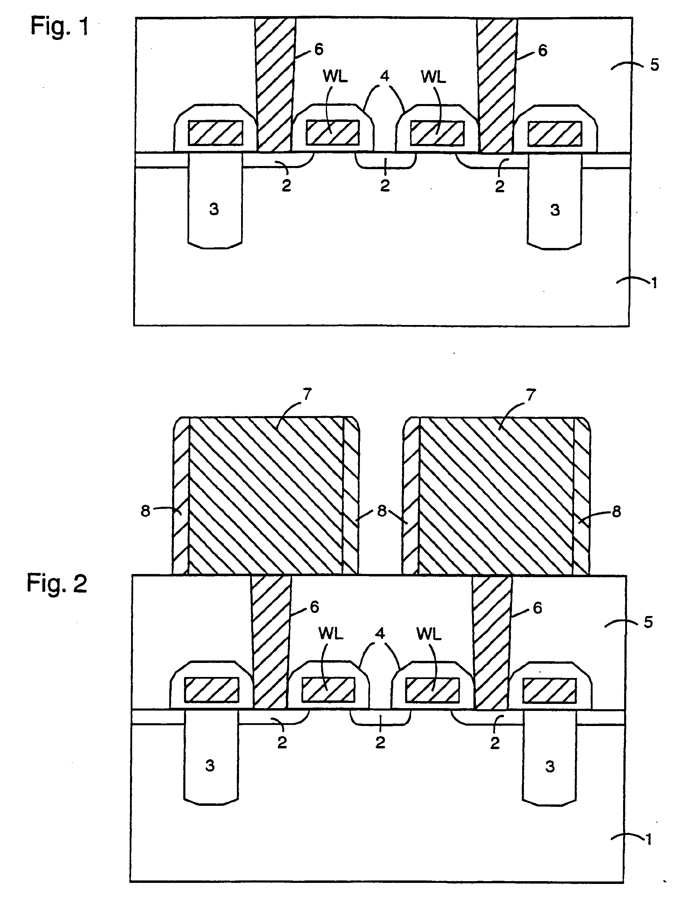

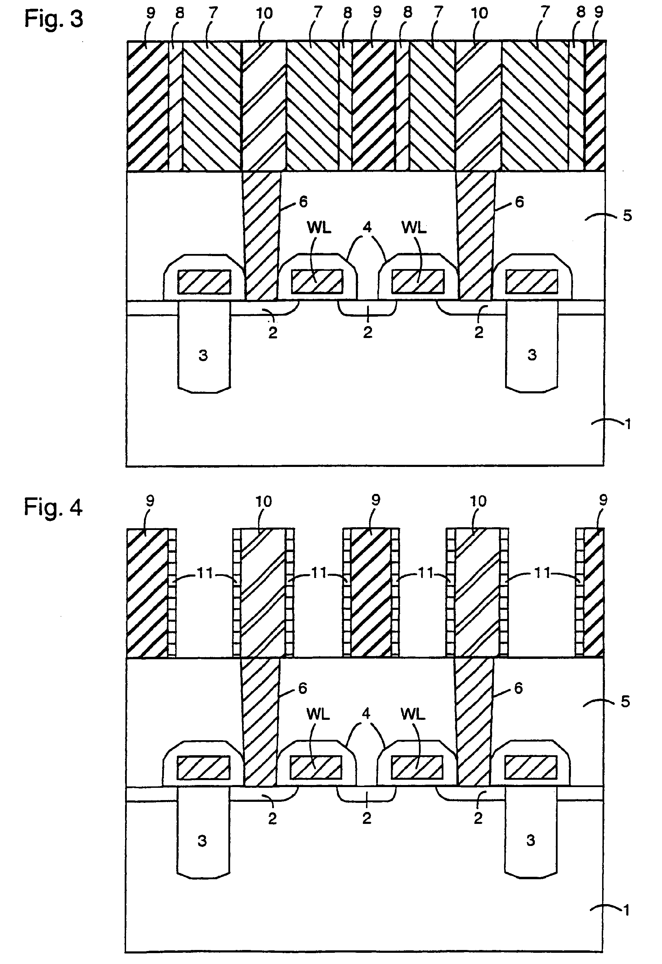

Die anhand der Fig. 1 und 2 erläuterten Schritte des ersten Ausführungsbeispiels gelten in gleicher Weise auch für das zweite Ausführungsbeispiel und werden zur Vereinfachung der Darstellung lediglich anhand des ersten Ausführungsbeispiels beschrieben.

Auch sind in den Schnittbildern der Figuren 1 bis 7 und 9 bis 14 nur einzelne Teile schraffiert dargestellt, um so die Zeichnungen möglichst übersichtlich zu gestalten.

Fig. 1 zeigt einen p-leitenden Halbleiterkörper 1, in den n⁺⁻leitende Gebiete 2 als Source bzw. Drain zwischen Isolationen 3 aus beispielsweise Siliziumdioxid eingebettet sind. Oberhalb des Halbleiterkörpers 1 sind Wortleitungen WL in Isoliermaterial 4 aus beispielsweise Siliziumdioxid vorgesehen. Bitleitungen verlaufen vor bzw. hinter der Zeichenebene senkrecht zu den Wortleitungen WL und sind in den Schnittdarstellungen der Figuren nicht gezeigt.

Auf der Oberfläche des Halbleiterkörpers 1 befindet sich noch eine Zwischenoxidschicht 5 aus beispielsweise Siliziumdioxid, durch die sich erste Plugs 6 aus dotiertem polykristallinem Silizium zur Kontaktierung der Gebiete 2 erstrecken.

Auf die so hergestellte Anordnung wird, wie in Fig. 2 gezeigt ist, zunächst polykristallines Silizium mit einer Schichtdikke von 500 nm abgeschieden, das mit Hilfe einer Photo- und Ätztechnik strukturiert wird, so daß nach Abtragen des Lackes polykristalline Siliziumschichten 7 im Bereich oberhalb der ersten Plugs 6 zurückbleiben. Gegebenenfalls können diese polykristallinen Siliziumschichten 7 noch mit Abstands- bzw. Spacer-Schichten 8 mit einer Schichtdicke von etwa 50 nm verstärkt werden. Diese Schichten 8 brauchen aber nicht aufgetragen zu werden.

Es schließt sich sodann eine Abscheidung von Ruthenium durch CVD mit einer Schichtdicke von etwa 100 nm an, das chemisch-mechanisch poliert wird, so daß in den "Spalten" zwischen den Schichten 7 bzw. 8 Rutheniumschichten 9 zurückbleiben.

Durch eine weitere Photo- und Ätztechnik werden in die polykristallinen Siliziumschichten 7 im Bereich direkt oberhalb der Plugs 6 Löcher geätzt, die mit Isoliermaterial aus beispielsweise Siliziumnitrid aufgefüllt werden, so daß Isolierschichten 10 in diesen Löchern direkt oberhalb der ersten Plugs 6 gebildet werden. Nach einem Rückätzen des Siliziumnitrids entsteht so die in Fig. 3 gezeigte Struktur.

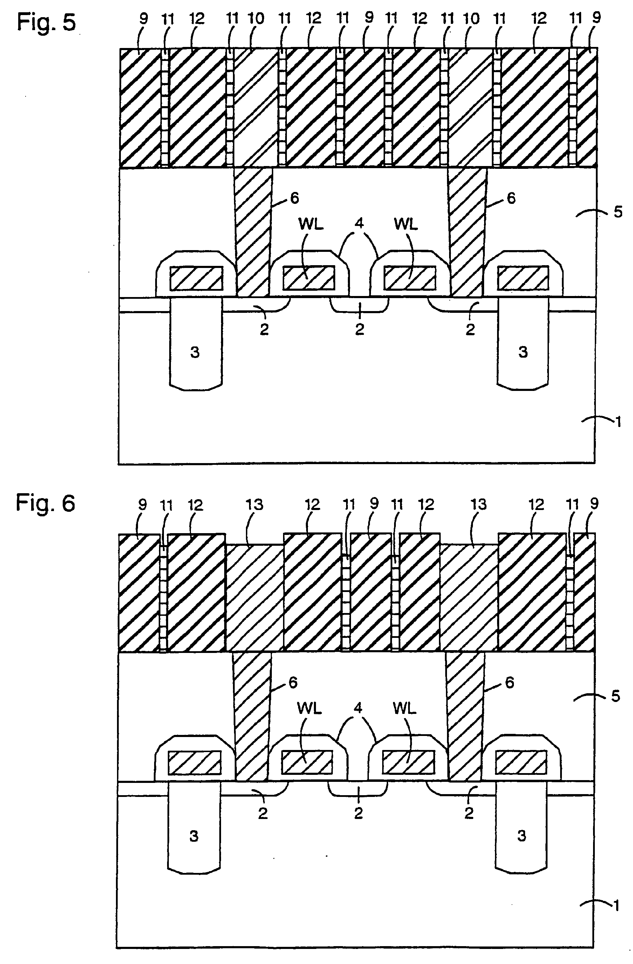

Durch Naßätzen werden anschließend die polykristallinen Siliziumschichten 7, 8 entfernt, so daß lediglich die Rutheniumschichten 9 und die Isolierschichten 10 zurückbleiben. Auf die so erhaltene Struktur wird ein Dielektrikum, wie beispielsweise BST, abgeschieden, das anschließend durch Ätzen so strukturiert wird, daß es nur auf den Seitenwänden der Gräben zurückbleibt und dort ein Dielektrikum 11 bildet. Es wird damit die in Fig. 4 gezeigte Struktur erhalten.

Durch CVD wird sodann erneut Ruthenium mit einer Schichtdicke von etwa 200 nm in die Gräben zwischen die Dielektrika 11 eingebracht und chemisch-mechanisch poliert, wodurch die in Fig. 5 gezeigte Struktur erhalten wird, in welcher Ruthenium-Elektroden 12 beidseitig von den BST-Dielektrika 11 angeordnet sind.

Anschließend wird die als "Platzhalter" dienende Siliziumnitridschicht 10 durch Naßätzen entfernt. Diese Siliziumnitridschicht 10 schützte die Plugs 6 bei der Temperung der BST-Dielektrika 11 (vgl. Fig. 4) vor einem Aufoxidieren mit Sauerstoff. Nach dem Abtragen der Siliziumnitridschicht 10 und dem Naßätzen der an diese Siliziumnitridschicht 10 angrenzenden BST-Dielektrika 11 werden die so gebildeten Gräben mit dotiertem polykristallinem Silizium gefüllt, so daß zweite Plugs 13 entstehen, die in direkter Verbindung zu den ersten Plugs 6 sind. Die Plugs 6, 13 sind gegebenenfalls n⁺-dotiert. Nach dem Rückätzen der Plugs 13 wird die in Fig. 6 gezeigte Struktur erhalten.

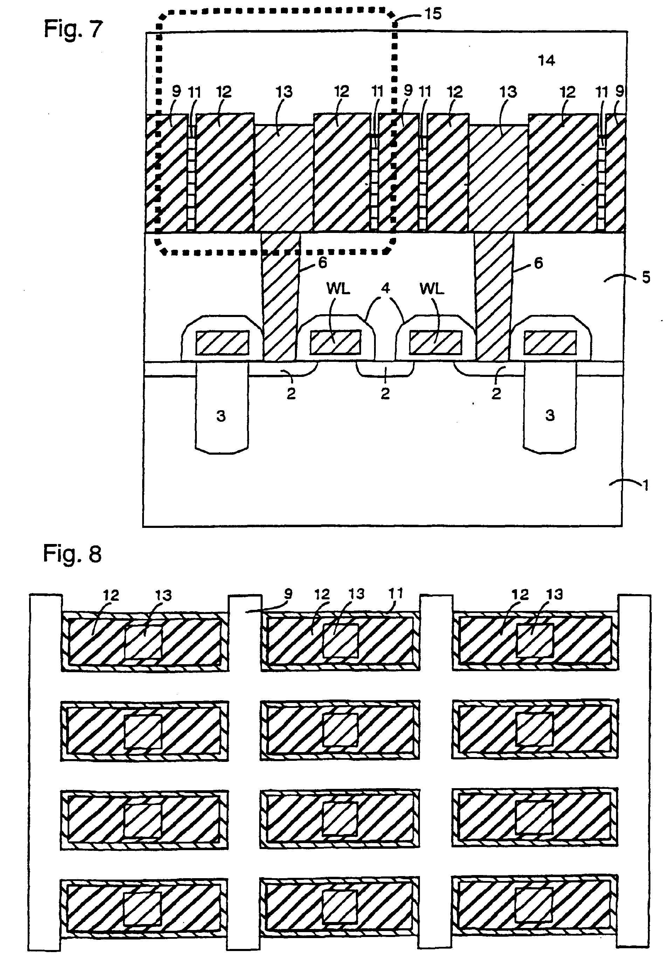

Es schließt sich sodann noch eine TEOS-Abscheidung (TEOS = Tetraethylenorthosilikat) an, um eine Siliziumdioxidschicht 14 zu bilden, wodurch die in Fig. 7 gezeigte Struktur vorliegt, in welcher ein Kondensator 15 einer einzelnen Zelle gesondert herausgestellt ist.

Fig. 8 zeigt eine Draufsicht auf mit dem erfindungsgemäßen Verfahren erhaltene Speicherzellen mit den ein netzförmiges Muster bildenden Rutheniumschichten 9, den zweiten Plugs 13, den BST-Dielektrika 11 und Ruthenium-Knoten 12 (gebildet durch die an die Plugs 13 angrenzenden Rutheniumschichten 12). Die netzförmigen Rutheniumschichten 9 bilden eine Zellplattenelektrode der Speicherkondensatoren.

Es sei angemerkt, daß die Fig. 1 bis 7 Schnitte durch die Fig. 8 in horizontaler Richtung zeigen, wobei allerdings diese Schnitte die einzelnen Strukturen der Fig. 8 nicht in jeweils gleichem Maßstab wiedergeben.

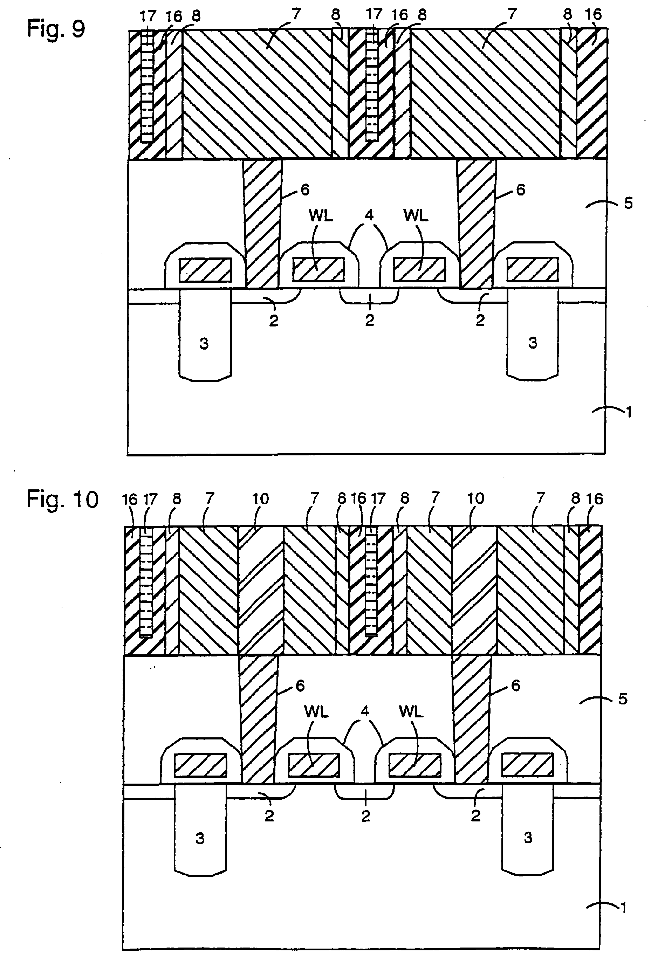

Im folgenden wird anhand der Fig. 9 bis 15 ein zweites Ausführungsbeispiel des erfindungsgemäßen Verfahrens zum Herstellen einer Speicherzelle erläutert, das sich an die oben mit Hilfe der Fig. 1 und 2 erläuterten Verfahrensschritte anschließt.

Wie in Fig. 9 gezeigt ist, werden die Gräben zwischen den polykristallinen Siliziumschichten 7, 8 (vgl. Fig. 2) gefüllt, indem zunächst eine 50 nm dicke Platinschicht durch Sputtern aufgetragen wird, die anschließend chemisch-mechanisch poliert wird, so daß eine Platinschicht 16 entsteht. Die Zwischenräume dieser Platinschicht 16 werden mit einer etwa 50 nm dicken Wolframschicht 17 gefüllt, die durch CVD abgeschieden und anschließend chemisch-mechanisch poliert wird. Es wird dann, wie in Fig. 10 gezeigt ist, ähnlich wie in dem anhand von Fig. 3 erläuterten Schritt des ersten Ausführungsbeispiels eine Strukturierung der polykristallinen Siliziumschichten 7, 8 vorgenommen, um in diesen Löcher zu erzeugen, die mit einer Silziumnitridschicht 10 gefüllt werden. Wie im ersten Ausführungsbeispiel liegen auch im zweiten Ausführungsbeispiel die Löcher bzw. die in diese gefüllten Siliziumnitridschichten 10 direkt oberhalb der ersten Plugs 6, so daß sie dort einen Platzhalter während anschließender Temperbehandlungen bilden, um die ersten Plugs 6 vor einer Aufoxidation in einer Sauerstoffatmosphäre zu schützen. Nach Rückätzen des Siliziumnitrids wird so die in Fig. 10 gezeigte Struktur erhalten.

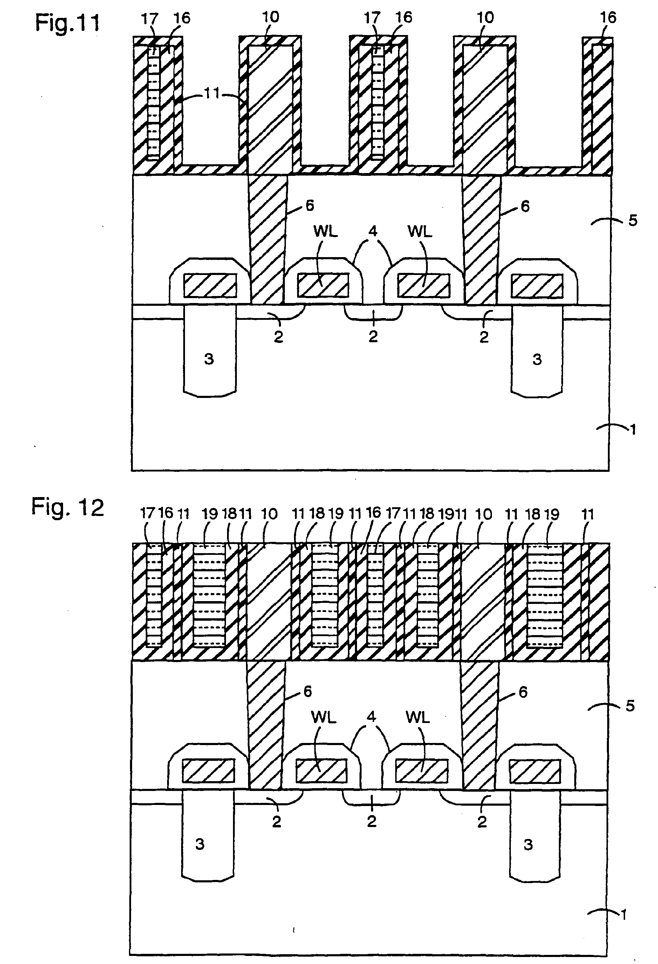

Durch Naßätzen werden anschließend die polykristallinen Siliziumschichten 7, 8 entfernt, und auf die so geschaffene Struktur wird BST ganzflächig abgeschieden, so daß die in Fig. 11 gezeigte Anordnung mit einem BST-Dielektrikum 11 entsteht.

Es schließt sich das Abscheiden einer Platinschicht 18 an, die anschließend chemisch-mechanisch poliert wird. Sodann wird das BST-Dielektrikum 11 getempert. Bei diesem Temperprozeß sind die ersten Plugs 6 durch die Siliziumnitridschicht 10 geschützt, so daß keine Aufoxidation an der Oberfläche der ersten Plugs 6 auftritt.

Schließlich werden die Zwischenräume in der Platinschicht 18 noch mit einer etwa 50 nm dicken Wolframschicht 19 aufgefüllt, die durch CVD aufgebracht und anschließend chemisch-mechanisch poliert wird. Es liegt damit die in Fig. 12 gezeigte Struktur vor.

Ähnlich zu dem anhand der Fig. 6 erläuterten Schritt wird sodann die Siliziumnitridschicht 10 durch Naßätzen abgetragen.

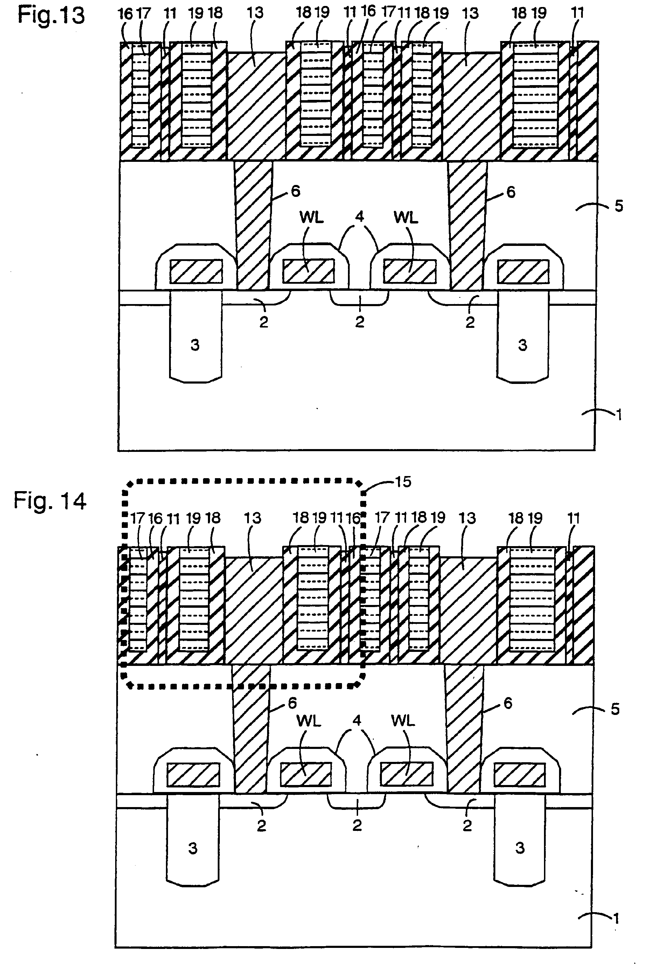

Es schließt sich sodann die Abscheidung einer dotierten polykristallinen Siliziumschicht an, die damit die zweiten Plugs 13 oberhalb der ersten Plugs 6 bildet, so daß die Plugs 6, 13 in direktem Kontakt miteinander sind. Nach Rückätzen des polykristallinen Siliziums wird so die in Fig. 13 gezeigte Struktur erhalten.

Anschließend wird noch eine TEOS-Siliziumdioxidschicht 14 aufgetragen, wodurch die Speicherzelle fertiggestellt ist, in der wiederum ein Kondensator 15 einer Einzelzelle gesondert herausgestellt ist.

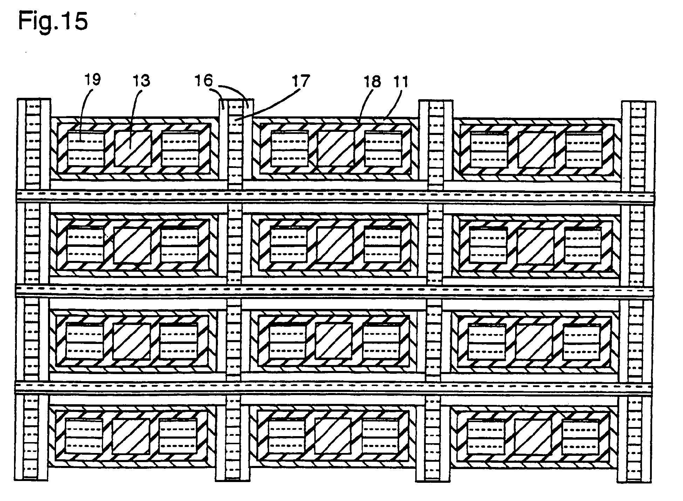

Fig. 15 zeigt eine Draufsicht auf die mit dem Verfahren nach dem zweiten Ausführungsbeispiel erhaltene Speicherzelle, ähnlich zu Fig. 8 für das erste Ausführungsbeispiel. Auch zeigen die Fig. 9 bis 14 Schnitte, die in horizontaler Richtung durch die Anordnung von Fig. 15 verlaufen.

Wesentlich an der vorliegenden Erfindung ist, daß die ersten Plugs 6 während der Temperprozesse durch die Isolierschicht 10 aus beispielsweise Siliziumnitrid abgedeckt werden, so daß diese ersten Plugs keiner Aufoxidation in einer Sauerstoffatmosphäre unterliegen. Nach den Temperprozessen wird die als Platzhalter dienende Isolierschicht 10 entfernt, um durch dotiertes polykristallines Silizium ersetzt zu werden, das dann die zweiten Plugs 13 bildet, die in direktem Kontakt zu den ersten Plugs 6 sind.

Die einzelnen Prozeßschritte sind in hochgradigem Ausmaß zueinander selbstjustiert, so daß eine große Genauigkeit zu erzielen ist. Auch wird die Zellfläche für den Speicherkondensator in optimaler Weise ausgenutzt. Barriereschichten werden nicht benötigt, da, wie oben erläutert wurde, während der Temperprozesse das polykristalline Silizium der ersten Plugs durch die Isolierschicht geschützt ist. Es sei nochmals angemerkt, daß anstelle von Ruthenium, Platin und Wolfram, die in den obigen Ausführungsbeispielen Verwendung finden, auch andere Materialien eingesetzt werden können, wie diese speziell aus der US 5 554 866 bekannt sind.

Schließlich wird bei der Erfindung zuerst die Zellplattenelektrode (vgl. beispielsweise die Rutheniumschichten 9 in den Fig. 3 und 4) erzeugt und als netzförmiges Muster ausgebildet. In diese Hilfsstruktur werden sodann die Kontaktlöcher für den Zellknotenanschluß geätzt und mit der Isolierschicht aus beispielsweise Siliziumnitrid als Platzhalter aufgefüllt. Damit kann die oxidierende Temperung bei hohen Temperaturen auf das BST angewandt werden. Erst zum Schluß wird sodann der Platzhalter aus beispielsweise Siliziumnitrid durch polykristallines Silizium ersetzt.

## Patentansprüche

1. Verfahren zum Herstellen einer Speicherzelle aus wenigstens einem Auswahltransistor und einem Speicherkondensator mit einem Hochepsilon- oder ferroelektrischen Dielektrikum (11), bei dem der Auswahltransistor in einer ersten Ebene und der Speicherkondensator in einer zweiten Ebene in beziehungsweise über einem Halbleiterkörper (1) angeordnet werden, wobei die erste Ebene mit der zweiten Ebene elektrisch durch einen ersten Plug (6) aus Silizium verbunden ist, an den sich ein zweiter Plug (13) aus Silizium anschließt, der mit einer Speicherknotenelektrode (12) des Speicherkondensators elektrisch verbunden ist,
**dadurch gekennzeichnet,**
- **daß** eine polykristalline Siliziumschicht (7) auf dem Halbleiterkörper (1) mit einem Zwischenraum zwischen zwei benachbarten Strukturen der polykristallinen Siliziumschicht (7) gebildet wird, wobei eine der benachbarten Strukturen der polykristallinen Siliziumschicht (7) auf der Oberfläche des ersten Plugs (6) angeordnet wird;
- **daß** in dem Zwischenraum eine Zellplattenelektrode (9) gebildet wird;
- **daß** in der polykristallinen Siliziumschicht (7) ein Loch gebildet wird, das bis an die Oberfläche des ersten Plugs (6) heranreicht und mit einer Isolierschicht (10) gefüllt wird;
- **daß** die polykristalline Siliziumschicht (7) entfernt wird;
- **daß** nachfolgend das Dielektrikum (11) und die Speicherknotenelektrode (12) gebildet werden;
- und **daß** nachfolgend die Isolierschicht (10) durch Silizium ersetzt wird, das den zweiten Plug (13) in direkter Verbindung mit dem ersten Plug (6) bildet.

2. Verfahren nach Anspruch 1,
**dadurch gekennzeichnet, daß**
an einer Struktur der polykristallinen Siliziumschicht (7) ein seitlicher Randsteg (8) gebildet wird.

3. Verfahren nach einem der Ansprüche 1 oder 2,
**dadurch gekennzeichnet, daß**
die Zellplattenelektrode (9) aus einer konformen Schicht (16) und einer Füllung (17) gebildet wird.

4. Verfahren nach einem der Ansprüche 1 bis 3,
**dadurch gekennzeichnet, daß**
die Isolierschicht (10) aus Siliziumnitrid gebildet wird.

5. Verfahren nach einem der Ansprüche 1 bis 4,
**dadurch gekennzeichnet, daß**
die Bildung einer der Elektroden (9, 12) durch chemische Dampfabscheidung erfolgt.

6. Verfahren nach einem der Ansprüche 1 bis 5,
**dadurch gekennzeichnet, daß**
die Bildung einer der Elektroden (9, 12) durch Sputtern erfolgt.

## Claims

1. Method for fabricating a memory cell comprising at least one selection transistor and a storage capacitor having a high-epsilon or ferroelectric dielectric (11), in which the selection transistor is arranged in a first plane and the storage capacitor is arranged in a second plane in and, respectively, above a semiconductor body (1), the first plane being electrically connected to the second plane by a first plug (6) made of silicon, which is adjoined by a second plug (13) made of silicon, which is electrically connected to a storage node electrode (12) of the storage capacitor,
**characterized**
- **in that** a polycrystalline silicon layer (7) is formed on the semiconductor body (1) with an interspace between two adjacent structures of the polycrystalline silicon layer (7), one of the adjacent structures of the polycrystalline silicon layer (7) being arranged on the surface of the first plug (6);
- **in that** a cell plate electrode (9) is formed in the interspace;
- **in that** a hole is formed in the polycrystalline silicon layer (7), which hole reaches as far as the surface of the first plug (6) and is filled with an insulating layer (10);
- **in that** the polycrystalline silicon layer (7) is removed;
- **in that** the dielectric (11) and the storage node electrode (12) are subsequently formed;
- and **in that** the insulating layer (10) is subsequently replaced by silicon, which forms the second plug (13) directly connected to the first plug (6).

2. Method according to claim 1,
**characterized in that**
a lateral edge web (8) is formed on a structure of the polycrystalline silicon layer (7).

3. Method according to either of claims 1 and 2,
**characterized in that**
the cell plate electrode (9) is formed from a conformal layer (16) and a filling (17).

4. Method according to one of claims 1 to 3,
**characterized in that**
the insulating layer (10) is formed from silicon nitride.

5. Method according to one of claims 1 to 4,
**characterized in that**
one of the electrodes (9, 12) is formed by chemical vapor deposition.

6. Method according to one of claims 1 to 5,
**characterized in that**
one of the electrodes (9, 12) is formed by sputtering.

## Revendications

1. Procédé de fabrication d'une cellule de mémoire constituée d'au moins un transistor de sélection et d'un condensateur de stockage ayant un diélectrique (11) ferroélectrique ou à epsilon élevé, procédé dans lequel le transistor de sélection est situé dans un premier plan et le condensateur de stockage est situé dans un deuxième plan dans respectivement au-dessus d'un corps semi-conducteur (1), le premier plan étant électriquement relié au deuxième plan par un premier bouchon (6) en silicium auquel se raccorde un deuxième bouchon (13) qui est relié électriquement à une électrode nodale de stockage (12) du condensateur de stockage,
**caractérisé en ce que**
- on forme une couche de silicium polycristalline (7) sur le corps semi-conducteur (1) en ménageant un espace intermédiaire entre deux structures voisines de la couche de silicium polycristalline (7), l'une des structures voisines de la couche de silicium polycristalline (7) étant située à la surface du premier bouchon (6) ;
- on forme une électrode à plaque de cellule (9) dans l'espace intermédiaire ;
- on ménage un trou dans la couche de silicium polycristalline, lequel trou va jusqu'à la surface du premier bouchon (6) et est rempli d'une couche isolante (10) ;
- on élimine la couche de silicium polycristalline (7) ;
- puis, on forme le diélectrique (11) et l'électrode nodale de stockage (12) ;
- et enfin on remplace la couche isolante (10) par du silicium qui forme le deuxième bouchon (13) en liaison directe avec le premier bouchon (6).

2. Procédé selon la revendication 1, **caractérisé en ce que** l'on forme une nervure de bordure latérale (8) sur une structure de la couche de silicium polycristalline (7).

3. Procédé selon l'une des revendications 1 ou 2, **caractérisé en ce que** l'on forme l'électrode à plaque de cellule (9) d'une couche conforme (16) et d'une matière de remplissage (17).

4. Procédé selon l'une des revendications 1 à 3, **caractérisé en ce que** la couche isolante (10) est en nitrure de silicium.

5. Procédé selon l'une des revendications 1 à 4, **caractérisé en ce que** l'on effectue la formation de l'une des électrodes (9, 12) par dépôt chimique en phase vapeur.

6. Procédé selon l'une des revendications 1 à 5, **caractérisé en ce que** l'on effectue la formation de l'une des électrodes (9, 12) par pulvérisation cathodique.
